# EUROPÄISCHE PATENTSCHRIFT

(11) **EP 4 348 369 B1**
(45) Veröffentlichungstag und Bekanntmachung des Hinweises auf die Patenterteilung: **23.09.2026**
(21) Anmeldenummer: 22761136.5
(22) Anmeldetag: 03.08.2022
(51) Int. Cl.: G05B 23/02, G05B 19/042

(54) **COMPUTERIMPLEMENTIERTES VERFAHREN ZUM ÜBERPRÜFEN VON LASTKREISEN EINER TECHNISCHEN ANLAGE**
COMPUTER-IMPLEMENTED METHOD FOR CHECKING LOAD CIRCUITS IN A TECHNICAL PLANT
PROCÉDÉ MIS EN OEUVRE PAR ORDINATEUR POUR VÉRIFIER LES CIRCUITS DE CHARGE D'UNE INSTALLATION TECHNIQUE

(30) Priorität: 11.08.2021 EP 21190766
(43) Veröffentlichungstag der Anmeldung: 10.04.2024
(73) Patentinhaber: Siemens Aktiengesellschaft, 80333 München (DE)
(72) Erfinder: PAL, Markus, 7400 Oberwart (AT)
(74) Vertreter: Siemens Patent Attorneys
(86) Internationale Anmeldenummer: PCT/EP2022/071798
(87) Internationale Veröffentlichungsnummer: WO 2023/016881

(56) Entgegenhaltungen:
- EP-A1- 3 786 747
- WO-A1-2021/037835
- KR-B1- 101 088 795

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf ein Verfahren zum Überprüfen von Lastkreisen eines Steuersystems einer technischen Anlage. Dabei weist das Steuersystem neben zumindest zwei Lastkreisen mit jeweils zumindest einer Lasteinheit (z.B. Sensor, Aktor, Relais, Schütz, Magnetventil, Stellmotor, etc.) zumindest eine Steuereinheit sowie eine getaktete Stromversorgung auf. Von der getakteten Stromversorgung werden die zumindest zwei Lastkreise über zumindest zwei Ausgangskanäle mit einer Versorgungsspannung und/oder mit einem Versorgungsstrom versorgt, welche in Spannungs- und/oder Stromhöhe variierbar sind. Von der Steuereinheit werden die zumindest zwei Ausgangskanäle sowie Steuerausgänge der Steuereinheit durch Signale angesteuert und dadurch unterschiedliche Anlagenzustände hervorgerufen.

### Stand der Technik

In vielen Bereichen, vor allem in der industriellen Produktion und Fertigung, in der Automatisierungstechnik, etc., kommen heutzutage komplexe Anlagen und/oder Maschinen zum Einsatz. Unter einer Anlage wird dabei eine planvolle Zusammenstellung von Komponenten z.B. Maschinen, Geräten und/oder Apparaten) verstanden, welche in einem räumlichen Zusammenhang stehen und funktional, steuerungstechnisch und/oder sicherheitstechnisch miteinander verknüpft sind. Derartige Anlagen (z.B. Produktionsanlagen, Fertigungsanlagen, etc.) sowie ihre Komponenten weisen zusehend eine zunehmende Komplexität auf.

Für einen effizienten Betrieb von technischen Anlagen und komplexen Maschinen werden daher üblicherweise Steuerungssysteme eingesetzt, durch welche der Betrieb der Maschine bzw. Anlage möglichst selbständig und unabhängig von menschlichen Eingriffen erfolgen soll. Daher werden von einem derartigen Steuersystem mittels Sensor- oder Messeinheiten Parameterwerte der Anlage oder der Maschine ermittelt und in Abhängigkeit von den ermittelten Parameterwerten Aktoreinheiten oder Lasteinheiten (z.B. Schütze, Magnetventile, optische oder akustische Warnsignale, Motoreinheiten, Anzeigeeinheiten, etc.) entsprechend angesteuert. Für die Auswertung der von den Sensor- und Messeinheiten gelieferten Parameterwerte sowie für die Ansteuerung der Aktoreinheiten (z.B. Stellmotor, Warnsignal, Anzeigeeinheit, etc.) weist das Steuersystem der Anlage bzw. der Maschine üblicherweise eine Steuereinheit auf. Von der Steuereinheit können über entsprechende Eingänge Messsignale von Sensor- und Messeinheiten empfangen bzw. über entsprechende Steuerausgänge mittels Signalen die Aktoreinheiten angesteuert werden können. Weiterhin können mit dieser Steuereinheit über die entsprechenden Steuerausgänge der Steuereinheit z.B. entsprechend prozesstechnischer Erfordernisse unterschiedliche Lasteinheiten, wie z.B. Relais, Schütze, mittels eines Elektromagneten betätigbare Magnetventile, etc., mit Hilfe von Signale zu- oder weggeschaltet werden. Als Steuereinheit kann beispielsweise eine so genannte speicherprogrammierbare Steuerung oder SPS, ein Mikrocontroller oder ein Industrie-PC eingesetzt werden.

Weiterhin weist ein derartiges Steuersystem zumindest eine getaktete Stromversorgung (z.B. ein Schaltnetzteil) auf, von welcher eine unstabilisierte Eingangsspannung in eine konstante Ausgangsspannung (z.B. 24 Volt) zur Versorgung der Lasteinheiten des Steuersystems umgewandelt wird. Eine derartige Stromversorgung - wie z.B. die SITOP PSU8600 der Firma Siemens - weist beispielsweise zumindest zwei oder mehrere Ausgänge zum direkten Anschließen von Lastkreisen auf. Diese Ausgänge werden als Ausgangskanäle genutzt und sind durch Steuersignale der Steuereinheit ansteuerbar. Alternativ kann eine getaktete Stromversorgung eingesetzt werden, an welche beispielsweise über einen Ausgang der Stromversorgung eine Baugruppe, wie z.B. eine schaltbare Sicherungseinheit, etc., anschaltbar ist, von welcher z.B. zumindest zwei getrennt schaltbare Ausgangskanäle zur Verfügung gestellt werden. An die einzelnen Ausgangskanäle der Stromversorgung oder der schaltbaren Sicherungseinheit können Lastkreise mit zumindest einer Lasteinheit oder mit einer Gruppe von Lasteinheiten angeschlossen werden. Der jeweilige Lastkreis wird dann von der Stromversorgung über den jeweiligen Ausgangskanal mit einer Versorgungsspannung (z.B. 24 Volt) und/oder einem Versorgungsstrom versorgt.

Für eine Ansteuerung der Ausgangskanäle der Stromversorgung bzw. der schaltbaren Sicherungseinheit werden z.B. von der Steuereinheit entsprechende Signale zur Verfügung gestellt. Mittels dieser Signale wird die Spannungs- und/oder Stromversorgung des jeweiligen Lastkreises ein- bzw. ausgeschaltet. Die Steuereinheit kann damit die Ausgangskanäle ansteuern und die Versorgungsspannung oder den Versorgungsstrom in den Ausgangskanäle bzw. für den jeweils angeschlossenen Lastkreis beeinflussen.

Bei einer Stromversorgung mit zwei oder mehr Ausgangskanälen kann z.B. die Spannung und der Strom für jeden Ausgangskanal individuell eingestellt und überwacht werden. Das bedeutet, dass z.B. bei jedem Ausgangskanal der Stromversorgung die jeweilige Versorgungsspannung und/oder der Laststrom für den jeweils angeschlossenen Lastkreis gemessen und überwacht werden kann. Damit kann z.B. eine Stromverbrauch oder eine aktuelle Spannung in einem Lastkreis ermittelt und Veränderungen von Stromverbrauch oder Spannung in diesem Lastkreis durch Steuer- und Schalthandlungen der Steuereinheit des Steuersystems dokumentiert werden.

Nach Aufstellen, Erweitern, etc. bzw. bei Inbetriebnahme einer komplexen Maschine oder einer Anlage, aber auch während des operativen Einsatzes stellt eine Überprüfung auf Fehler einen wesentlichen Aspekt dar, um einen reibungslosen und sicheren Betrieb der Anlage zu gewährleisten. Vor allem beim Aufstellen, bei Erweiterung bzw. bei der Inbetriebnahme ist es wichtig, Bauteildefekte sowie so genannte Verdrahtungsfehler in der Anlage, insbesondere im Steuersystem der Anlage rechtzeitig zu erkennen. Unter Verdrahtungsfehlern werden vor allem Fehler beim Anschließen einer oder mehrerer Lasteinheiten an einen Lastkreis oder einen Ausgangskanal der Stromversorgung verstanden. Durch das rechtzeitige Erkennen von defekten Bauteilen in Lastkreisen sowie Fehlern bei der Verdrahtung werden ordnungsgemäße Abläufe in der Anlage - z.B. nach Erweiterung und/oder bei Inbetriebnahme - ermöglicht und vor allem Sensor- und/oder Aktoreinheiten vor Beschädigung bzw. Zerstörung geschützt. Weiterhin ist es wichtig, Fehler (z.B. Leitungsbruch in einem Lastkreis, Störungen und/oder Defekte bei Lasteinheiten z.B. aufgrund von Abnutzung, Verschleiß, etc.) während des operativen Einsatzes der Anlage rasch zu erkennen und zu lokalisieren, um eine lange Fehlersuche sowie einen gegebenenfalls längeren Stillstand der Anlage zu vermeiden.

Aus der Schrift WO 2021/037835 A1 ist ein Verfahren zum Überprüfen von Lastkreisen eines Steuersystems in einer technischen Anlage bzw. zum leichteren Auffinden und Eingrenzen von Bauteildefekten und Verdrahtungsfehlern bekannt. Das Steuersystem weist neben zumindest zwei Lastkreisen, welche jeweils zumindest eine Lasteinheiten (z.B. Schütz, Magnetventil, Sensoreinheit, Aktoreinheit, etc.) umfassen, zumindest eine Steuereinheit und eine getaktete Stromversorgung auf. Die Stromversorgung versorgt über zumindest zwei Ausgangskanäle die zumindest zwei Lastkreise mit einer Versorgungsspannung bzw. einem Versorgungsstrom. Über Signale der Steuereinheit werden die Ausgangskanäle und die Steuerausgänge der Steuereinheit angesteuert und dadurch unterschiedliche Anlagezustände hervorgerufen bzw. eingestellt. Zum Überprüfen der Lastkreise werden zuerst Referenzwerte für Strom oder Spannung bzw. weiterer Signale für jeweils vorgegebene Anlagenzustände ermittelt und abgespeichert. Bei einem vorgegebenen Anlagenzustand ist zumindest ein Ausgangskanal eingeschaltet, wodurch der jeweils zugehörige Lastkreis von der Stromversorgung mit einer vorgegebenen Versorgungsspannung bzw. mit einem vorgegebenen Versorgungsstrom versorgt wird. Weiterhin kann bei einem Anlagenzustand ein Steuerausgang der Steuereinheit aktiviert sein, welcher eine Lasteinheit (z.B. eine Schalteinheit, ein Relais, einen Schütz, etc.) ansteuert und diese im Lastkreis z.B. zu- oder wegschaltet. D.h. für einen Anlagenzustand kann beispielsweise zumindest ein Ausgangskanal und/oder ein Steuerausgang der Steuereinheit aktiviert sein. In einer Testphase werden vorgegebene Anlagenzustände durchlaufen und aktuelle Stromwerte bei vorgegebenen Spannungswerten der Versorgungsspannung oder aktuelle Spannungswerte bei vorgegebenen Stromwerten des Versorgungsstroms zumindest am jeweils eingeschalteten Ausgangskanal gemessen. Um gegebenenfalls defekte bzw. fehlerhafte Lastkreise zu erkennen, werden die aktuell gemessenen Werte mit den entsprechenden, gespeicherten Referenzwerten verglichen. Wird bei einem Anlagenzustand ein vorgegebener Toleranzbereich vom jeweiligen Vergleichsergebnis verlassen, so wird der zumindest eine Lastkreis angezeigt, welcher bei diesem Anlagenzustand aktiviert war.

Wird das in der Schrift WO 2021/037835 A1 beschriebene Verfahren allerdings vollumfänglich in einer komplexen Anlage angewendet, so entsteht eine Vielzahl an Rohdaten, welche einem Anwender zur Überprüfung der Anlage zur Verfügung stehen. Dabei werden zahlreiche Rohdaten zu Anlagenzuständen bzw. Informationen zu zugehörigen Lastkreisen ermittelt, welche nur bedingt brauchbare Aussagen über einen aktuellen Zustand der Anlage bieten bzw. zur Eingrenzung eines Bauteildefekts und/oder eines Verdrahtungsfehlers liefern können. Die vom Verfahren gelieferten Rohdaten bzw. Informationen können beispielsweise in drei Gruppen eingeteilt werden. Eine erste Gruppe bilden Informationen, welche brauchbare Aussagen über den Zustand der Anlage liefern und idealerweise für eine Fehlersuche herangezogen werden können. Eine zweite Gruppe bilden beispielsweise Informationen, welche für eine Aussage über den Zustand der Anlage (d.h. über Defekte und Verdrahtungsfehler) keinen Mehrwert liefern und dafür unbrauchbar sind. Eine dritte Gruppe stellen Informationen bzw. Rohdaten dar, welche zwar brauchbare Informationen über den Zustand der Anlage liefern, aber deren Informationsgehalt allerdings redundant ist. Um zur ersten Gruppe der Informationen bzw. Rohdaten - d.h. zu den für die Fehlersuche relevanten Informationen - nach Durchführung des aus der Schrift WO 2021/037835 A1 bekannten Verfahrens zu gelangen, ist es derzeit notwendig, sämtliche von Verfahren gelieferten Rohdaten z.B. manuell zu überprüfen. Dies kann vor allem bei komplexen Anlagen zu einem großen, zeitlichen Aufwand führen, um Bauteildefekte, Verdrahtungsfehler, etc. bei einer Vielzahl an Lastkreisen zu finden.

### Darstellung der Erfindung

Der Erfindung liegt daher die Aufgabe zugrunde, ein Verfahren zum Überprüfen von Lastkreisen einer Anlage bzw. eines Steuersystems einer Anlage anzugeben, durch welches ein Auffinden und Eingrenzen von Bauteildefekten und/oder Verdrahtungsfehlern im Vergleich zum Stand der Technik erheblich vereinfacht und beschleunigt wird.

Diese Aufgabe wird durch ein computerimplementiertes Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zum Überprüfen von Lastkreisen eines Steuersystems der eingangs angeführten Art, wobei das Steuersystem neben zumindest zwei Lastkreisen mit zumindest jeweils einer Lasteinheit (z.B. Schütz, Magnetventil, Sensoreinheit, Aktoreinheit, etc.) zumindest eine Steuereinheit und eine Stromversorgung aufweist. Von der Stromversorgung werden die zumindest zwei Lastkreise über zumindest zwei Ausgangskanäle mit einer Versorgungsspannung und/oder einem Versorgungsstrom versorgt. Von der Steuereinheit werden die zumindest zwei Ausgangskanäle sowie die Steuerausgänge der Steuereinheit durch entsprechende Signale angesteuert und damit unterschiedliche Anlagenzustände hervorgerufen. Dabei weist das Verfahren die folgenden Schritte auf:
- Vorgeben von Anlagenzuständen, wobei die Anlagenzustände zumindest in Basiszustände, bei welchen zumindest ein Ausgangskanal oder ein Steuerausgang aktiv geschaltet ist, und Kombinationszustände, welche aus einer Kombination von zumindest zwei Basiszustände gebildet werden, unterteilt werden und wobei jedem Anlagenzustand zu ermittelnde Parameter zugeordnet werden;
- Ermitteln und Abspeichern von Referenzwerten der Parameter für die jeweils vorgegebenen Anlagenzustände;
- Ermitteln und Abspeichern von aktuellen Parameterwerten für die jeweils vorgegebenen Anlagenzustände;
- Vergleichen der ermittelten, aktuellen Parameterwerte mit den entsprechenden Referenzwerten, wobei jene ermittelten, aktuellen Parameterwerte mit dem jeweils zugeordneten Anlagenzustand als Elemente in einer Abweichliste gespeichert werden, welche von den entsprechenden Referenzwerten abweichen;
- Filtern der Abweichliste zum Generieren einer Ergebnisliste, wobei für jedes Element der Abweichliste geprüft wird, ob der Anlagenzustand des jeweiligen Elements ein Basiszustand oder ein Kombinationszustand ist. Ist der Anlagenzustand des jeweiligen Elements ein Basiszustand, dann wird das jeweilige Element in die Ergebnisliste übertragen. Ist der Anlagenzustand des jeweiligen Elements ein Kombinationszustand, dann wird geprüft, ob die Abweichliste zumindest ein Element mit einem jener Basiszustände als Anlagenzustand aufweist, aus welchen der Kombinationszustand des Elements zusammengesetzt ist. Wird kein derartiges Element in der Abweichliste gefunden, so wird das jeweilige Element in die Ergebnisliste übertragen. Wird zumindest ein Element in der Abweichliste gefunden, welches einen jener Basiszustände aufweist, aus welchen der Kombinationszustand des jeweiligen Elements zusammengesetzt ist, so werden die ermittelten Parameterwerte der Elemente überprüft und das jeweilige Element nur dann in die Ergebnisliste übertragen, wenn sein Parameterwert wertmäßig (d.h. der ermittelte Parameterwert) oder typmäßig (d.h. der Typ bzw. Art des zu ermittelnden Parameters, wie z.B. Spannung, Strom, Temperatur, Sensorwert, Signalwert, etc.) vom Parameterwert des zumindest einen gefundenen Elements abweicht.

Der Hauptaspekt der erfindungsgemäß vorgeschlagenen Lösung besteht darin, dass eine entsprechende zweifache Filterung der ermittelten, aktuellen Parameterwerte für die jeweils vorgegebenen Anlagenzustände ein Auffinden und Eingrenzen von Bauteildefekten und/oder Verdrahtungsfehlern in einer Anlage oder komplexen Maschine erheblich vereinfacht und beschleunigt wird. Eine erste Filterung wird durch den Vergleich zwischen den aktuell ermittelten Parameterwerten und den entsprechenden Referenzwerten für die jeweils vorgegebenen Anlagenzustände erzielt. Ein weitere Filterung der Information wird durch Filtern des Vergleichsergebnisses bzw. der Abweichliste erzielt, wobei anhand der zumindest in Basiszustände und Kombinationszustände unterteilten Anlagenzustände redundante Informationen entfernt werden. Idealerweise werden dabei sowohl Anlagenzustände sowie Parameterwerte mit redundanter Information herausgefiltert und nur mehr brauchbare Informationen in Form von Elementen bestehend aus einem Anlagenzustand einem ermittelten Parameterwert eines dem Anlagenzustand zugeordnetem Parameter in die Ergebnisliste aufgenommen. Einem Anwender wird nach einem Durchlauf des Verfahrens eine Ergebnisliste mit nur mehr brauchbaren Informationen bzw. Daten für eine weitere Verarbeitung und Analyse der Anlage zur Verfügung gestellt.

Durch die im Verfahren vorgenommenen Filterungen - d.h. Vergleich aktueller Parameterwerte mit entsprechenden Referenzwerten und Filterung der Abweichliste - werden unbrauchbare und/oder redundante Informationen herausgefiltert und damit eine deutliche Daten-Reduktion bei den weiterzuverarbeitenden bzw. zu analysierenden Daten erzielt. Die Fehlersuche kann dann mit Hilfe dieser reduzierten Datenmenge (d.h. mit der Ergebnisliste, in welcher relevante Elemente mit vom entsprechenden Referenzwert abweichendem Parameterwert und jeweils zugehörigem Anlagenzustand) eingeschränkt werden und damit eine deutliche Zeitersparnis bei der Weiterverarbeitung erreicht werden. Dabei geben die entsprechenden Anlagenzustände und gegebenenfalls die abweichenden Parameterwerte die zu analysierenden Lastkreise des Steuersystems an, in welche z.B. Verdrahtungsfehler, Bauteildefekte und/oder andere Defekte (z.B. Leitungsbruch, etc.) vorliegen können. Eine z.B. fehlerhafte Verdrahtung eines Lastkreises und/oder eine nicht korrekt eingesetzte bzw. verbaute Lasteinheit kann damit sehr einfach, rasch und gegebenfalls automatisiert - wenn z.B. vorgegebene Anlagenzustände in Form eines Testprogramms durchlaufen werden - erkannt werden.

Weiterhin bietet das erfindungsgemäße Verfahren den Vorteil, dass es computerimplementiert, d.h. automatisiert z.B. in der Steuereinheit oder in einer mit der Anlage verbindbaren Weiterverarbeitungseinheit (z.B. Rechnereinheit, Industrie-PC, etc.) durchgeführt wird. Vor allem die Filterung der Abweichliste und das Generieren der Ergebnisliste kann automatisiert beispielsweise auf einer Rechnereinheit getrennt von der Anlage ausgeführt werden, wodurch eine erhebliche Zeitersparnis und eine Reduktion des Analyseaufwands erreicht werden.

Es ist vorteilhaft, wenn jene Elemente der Ergebnisliste, welche als Anlagenzustand einen Basiszustand aufweisen, überprüft werden, ob bei diesen Elementen ermittelte Parameterwerte angeführt sind, welche wertmäßig und typmäßig übereinstimmen. D.h. die Ergebnisliste wird darauf überprüft, ob bei allen Elementen der Ergebnisliste mit einem Basiszustand als Anlagenzustand ein bestimmter Parameterwert auftaucht, welcher denselben Wert und denselben Parametertyp (z.B. Spannung an einem Ausgangskanal, Strom an einem Ausgangskanal, Signalwert an einem Steuerausgang oder Eingang, etc.) aufweist.

Dieser Parameterwert wird dann aus der Ergebnisliste gefiltert bzw. wenn kein weiterer Parameterwert abweicht, so wird das entsprechende Element (d.h. der jeweilige Parameter und der jeweils zugehörige Anlagenzustand bzw. Basiszustand) aus der Ergebnisliste gefiltert. Am Ende der Liste wird dann z.B. ein Verweis auf diesen Parameterwert bzw. das jeweilige Element der Ergebnisliste eingefügt. Diese zusätzliche Filterung der Ergebnisliste betrifft Ausgangskanäle bzw. Steuerausgänge der Steuereinheit, welche während einer Durchführung des Verfahrens dauerhaft aktiviert bleiben müssen, da z.B. die Steuereinheit über diesen Ausgangskanal laufend mit Spannung bzw. Strom versorgt wird oder z.B. der Luftdruck als Sensorwert immer vorhanden ist. Derartige dauerhaft aktivierte Ausgangskanäle oder Steuerausgänge bzw. Eingänge der Steuereinheit können beispielsweise bei allen Anlagenzuständen Parameterwerte generieren. Weicht nun einer dieser Parameterwerte ab, dann wird dieser Parameterwert z.B. bei allen Anlagenzuständen als abweichend angezeigt und vor allem für jene Anlagenzustände, welche als Basiszustände definiert sind, in der Ergebnisliste als abweichend angeführt. Durch die zusätzliche Filterung werden diese Parameterwerte und gegebenenfalls die zugehörigen Anlagenzustände (d.h. die entsprechenden Element) aus der Ergebnisliste entfernt und die Ergebnisliste für die Weiterverarbeitung konsistent und kurz gehalten.

Es ist weiterhin günstig, wenn die Ergebnisliste für eine Weiterverarbeitung weitergeleitet und/oder ausgegeben wird, wobei Elemente der Ergebnisliste mit identen Anlagenzustände zusammengefasst werden. Die Ausgabe der Ergebnisliste kann beispielsweise in Form einer Textdatei erfolgen, welche dann z.B. in einer Datenverarbeitungseinheit (z.B. Recheneinheit, Industrie-PC) oder manuell von einem Anwender ausgewertet wird. Alternativ kann die Ergebnisliste z.B. derart ausgewertet und aufbereitet werden, dass dem Anwender beispielsweise über eine Anzeige der Datenverarbeitungseinheit oder über eine mit der Datenverarbeitungseinheit verbundene Ausgabeeinheit jene Lastkreise angezeigt werden, in welchen abweichende Parameterwerte ermittelt wurden. Idealerweise werden jene Elemente in der Ergebnisliste zusammengefasst, welche idente Anlagenzustände aufweisen, um die Ergebnisliste kurz und konsistent zu halten und für den Anwender einfach zu überblicken.

Eine vorteilhafte Ausführungsvariante der Erfindung sieht vor, dass als zu ermittelnde Parameter in Abhängigkeit vom jeweiligen Anlagenzustand zumindest eine Spannung an zumindest einem der zumindest zwei Ausgangskanäle, ein Strom an zumindest einem der zumindest zwei Ausgangskanäle, ein Signal an zumindest einem Steuerausgang der Steuereinheit und/oder ein Signal an zumindest einem Eingang der Steuereinheit vorgegeben werden. Dabei können beispielsweise nur Spannung und/oder Strom an im jeweiligen Anlagenzustand eingeschalteten Ausgangskanälen als zu ermittelte Parameter vorgegeben werden. Zusätzlich können aber auch Spannung und/oder Strom an im jeweiligen Anlagenzustand ausgeschalteten Ausgangskanälen als Parameter ermittelt werden. Die Ermittlung von Signalen an den Steuerausgängen und Eingängen der Steuereinheit als Parameter hilft auf einfache Weise zusätzlich Defekte und/oder Verdrahtungsfehler in der Anlage festzustellen. Bei den Steuerausgängen können z.B. Werte von Steuersignalen zum Zu- oder Wegschalten von Lasteinheiten in Lastkreisen abgefragt werden. Als Parameter an den Eingängen der Steuereinheit können beispielsweise Werte von Temperatursensoren, Drehzahlsensoren, Näherungsschalter-Ruhesignalen, Funktionssigalen, etc. abgefragt werden.

Es ist weiterhin von Vorteil, wenn beim Ermitteln der Referenzwerte der vorgegebenen Parameter und beim Ermitteln der aktuellen Werte der vorgegebenen Parameter die vorgegebenen Anlagenzustände in derselben Reihenfolge durchlaufen werden. Für die Ermittlung der Referenzwerte der vorgegebenen Parameter kann zwar die Abfolge der vorgegebenen Anlagenzustände beliebig gewählt werden. Diese Reihenfolge sollte beim Ermitteln der aktuellen Parameterwerte der vorgegebenen Parameter z.B. in der Selbsttestphase, Testinbetriebnahme der Anlage nach Installation oder Erweiterung, etc. allerdings eingehalten werden. Dadurch werden auf einfache Weise Abweichungen zwischen dem aktuell ermittelten Parameterwert und dem entsprechenden Referenzwert vermieden, welche z.B. durch Erwärmung der Anlage, durch kapazitive Aufladungen von Lasteinheiten in Lastkreisen in der Anlage, etc. beim Durchlaufen der vorgegeben Anlagenzustände entstehen können.

Es ist weiterhin günstig, wenn den vorgegebenen Anlagenzuständen mehrere Spannungswerte für die Versorgungsspannung vorgegeben werden, mit welchen im jeweils vorgegebenen Anlagenzustand zumindest einer der zumindest zwei Lastkreise, insbesondere ein im jeweiligen Anlagezustand aktivierter Lastkreis, versorgt werden. Dabei werden die Referenzwerte sowie aktuell zu ermittelnden Parameterwerte des jeweiligen Anlagenzustand jeweils für die vorgegebenen Spannungswerte der Versorgungsspannung gemessen. Jeder unterschiedliche Spannungswert der Versorgungsspannung für den im jeweiligen Anlagenzustand zumindest einen aktivierten Lastkreis bildet dabei einen eigenen, neuen Anlagenzustand, für welchen Referenzwerte und Parameterwerte für die zugeordneten Parameter zu ermitteln sind. Die vorgegebenen Spannungswerte für Versorgungsspannung für den jeweiligen Anlagenzustand können der Stromversorgung ebenfalls durch die Steuereinheit vorgegebenen werden oder am extern angeschalteten Ausgangszweig eingestellt werden.

Weiterhin empfiehlt es sich, die vorgegebenen Spannungswerte in vorgegebenen Spannungsschritten von einer Ausgangsversorgungsspannung (z.B. 0 Volt) bis zu einer Nennspannung (z.B. 28 Volt) oder bis zu einer Betriebsgrenze der zumindest einen an den jeweiligen Lastkreis angeschlossenen Lasteinheit angehoben werden. Durch eine Steigerung der Versorgungsspannung in vorgegebenen Spannungsschritten (z.B. in Stufen von 2 Volt) können beispielsweise lastkreisspezifische und/oder für die jeweilige Lasteinheit typische Parameterwerte (z.B. Stromwerte) gemessen werden, welche eine zusätzliche Unterstützung beim Auffinden von Verdrahtungsfehler und eventuellen Fehlfunktionen bieten. So können z.B. kleine Sensoren einen Linearregler mit interner Elektronik aufweisen, durch welche der Sensor erst ab einer bestimmten Versorgungsspannung (z.B. 5 Volt oder 12 Volt) eingeschaltet wird und welche bis zu einer bestimmten Spannung (z.B. 28 Volt) z.B. einen Stromverbrauch konstant hält. Leistungsstärkere Verbraucher, wie z.B. Steuereinheiten, etc., weisen z.B. einen Tiefsetzsteller, etc. zum Erzeugen einer internen Hilfsspannung auf und reduzieren beispielsweise mit steigender Versorgungsspannung den Strom. Ein Schütz als Lasteinheit weist z.B. einen linear steigenden Stromverbrauch mit steigender Versorgungsspannung auf. Ein Gleichstrommotor kann beispielsweise bei geringer Spannung einen sehr geringen Widerstand aufweisen und z.B. einen hohen Strom aufnehmen, welcher beispielsweise mit beginnender Drehbewegung in einer flachen Kurve steigt oder sogar sinken kann.

Alternativ zu einer schrittweisen Steigerung der Versorgungsspannung am zumindest jeweils einen eingeschalteten Ausgangskanal der Stromversorgung, kann es auch günstig sein, wenn die vorgegebenen Spannungswerte für die Versorgungsspannung in Form einer linearen Spannungsrampe mit vorgebbarer Steigung von einer Ausgangsversorgungsspannung (z.B. 0 Volt) bis zu einer vorgegebenen Nennspannung (z.B. 28 Volt) oder einer Betriebsgrenze der zumindest einen an den jeweiligen Lastkreis angeschlossenen Lastkreiseinheit angehoben werden.

Alternativ können anstatt Spannungswerten für die Versorgungsspannung auch mehrere Stromwerte für den Versorgungsstrom vorgegeben werden, mit welchen im jeweils vorgegebenen Anlagenzustand der zumindest eine aktivierte Lastkreis versorgt wird. Diese Stromwerte können ebenfalls schrittweise z.B. von einem Ausgangsstrom bis zu einem vorgegebenen maximalen Stromwert gesteigert oder linear mit vorgegebener Steigung angehoben werden.

Weiterhin ist es von Vorteil, wenn beim Ermitteln der Referenzwerte und beim Ermitteln der aktuellen Parameterwerte bei einer Änderung von einem vorgegebenen Anlagenzustand auf einen weiteren vorgegebenen Anlagenzustand eine vorgebbare Wartezeit eingehalten wird. Dadurch können beispielsweise Einflüsse von Strom- und/oder Spannungsschwankungen, welche durch Anschalten der Versorgungsspannung an den jeweiligen Lastkreis (d.h. Einschalten des entsprechenden Ausgangskanals) bzw. durch Ändern des Spannungswertes der Versorgungsspannung aufgrund der jeweiligen Lasteinheiten im Lastkreis entstehen, auf die Messung der jeweiligen Referenzwerte bzw. der aktuellen Parameterwerte, insbesondere auf Strom- oder Spannungswerte, möglichst eliminiert werden. Weiterhin kann durch Einhalten der vorgegebenen Wartezeit sichergestellt werden, dass z.B. Parameter eines vorherigen Anlagenzustands bereits wieder abgeklungen sind. So kann eine Sensoreinheit nach Deaktivierung des Anlagenzustands, in dem der zugehörige Lastkreis aktiviert war, z.B. im nachfolgenden Anlagenzustand zufällig liefern, da z.B. die Versorgungsspannung im zugehörigen Lastkreis bzw. Ausgangskanal nur langsam abfällt.

Die vorgebbare Wartezeit für die Ermittlung der Parameterwerte eines Anlagenzustands kann beispielweise derart gewählt werden, dass im zumindest einen aktiven Lastkreis des Anlagenzustands ein stabiler Strom erreicht wurde, welcher z.B. eine relative geringe Schwankung (z.B. 3% Abweichung in einer Sekunde) aufweist, oder dass ein Strom bzw. eine Spannung im zumindest einen Lastkreis abgeklungen ist, welcher im jeweils vorhergehenden Anlagenzustand aktiviert war. Ein Vorgabewert für die Wartezeit für die jeweiligen Lastkreise bzw. die entsprechenden Lasteinheiten kann z.B. während der Ermittlung der Referenzwerte bestimmt und dann bei der Ermittlung der Parameterwerte verwendet werden. Damit lassen sich z.B. Wartezeiten bei Lasteinheiten bzw. Lastkreisen ohne nennenswerte Einschwingzeit auf ein Minimum reduzieren. Bei Lasteinheiten mit relativ großen Einschwingzeiten kann beispielsweise zur vorgebbaren Wartezeit noch eine Sicherheitsreserve vorgesehen werden, um stabile Werte der zu ermittelnden Parameter zu erhalten.

Idealerweise werden die Referenzwerte der zu ermittelnden Parameter für die jeweiligen Anlagenzustände z.B. während einer Planungs- und Entwicklungsphase der Anlage mittels einer Referenzanlage z.B. beim Hersteller ermittelt. Damit stehen dann z.B. bei Inbetriebnahme von Anlagen desselben Typs (z.B. Serienanlage/-maschine) am jeweiligen Einsatzort die entsprechenden Referenzwerte zur Verfügung, welche für eine Überprüfung, ob die Lastkreise korrekt verdrahtet wurden und ob die richtigen Lasteinheiten an den jeweils geplanten Stellen bzw. in den geplanten Lastkreisen verbaut wurden und keine Bauteildefekte aufweisen, herangezogen werden können.

Alternativ können die Referenzwerte der zu ermittelnden Parameter für die jeweiligen Anlagenzustände während einer Inbetriebnahmephase der zu überprüfenden Anlage (z.B. bei einer Testinbetriebnahme beim Hersteller, etc.) ermittelt werden oder aus Parameterwerten abgeleitet werden, welche z.B. während eines laufenden Betriebs der Anlage laufend für unterschiedliche Anlagenzustände an den jeweiligen Ausgangskanälen und/oder Steuerausgängen der Steuereinheit gemessen werden. D.h., die Referenzwerte werden idealerweise aus früheren Messwerten abgeleitet, welche bei verschiedenen Anlagenzuständen (z.B. im laufenden Betrieb, bei einer Inbetriebnahme beim Hersteller oder beim Benutzer) gemessen wurden. Das ist insbesondere sinnvoll, wenn eine Anlage beispielsweise teilweise zerlegt, transportiert und wiederaufgestellt wird. Bei einer Wiederinbetriebnahme bzw. beim Wiedereinschalten kann dann einen korrekte Verdrahtung der Lastkreise des Anlagen-Steuersystems bzw. eine ordnungsgemäße Funktion der Lastkreise und der Lasteinheiten sehr einfach überprüft werden.

### Kurzbeschreibung der Zeichnung

Die Erfindung wird nachfolgend in beispielhafter Weise anhand der beigefügten Figuren erläutert. Es zeigen:
Figur 1 einen schematischen und beispielhaften Aufbau eines Steuersystems einer Anlage zur Durchführung des erfindungsgemäßen Verfahren zum Überprüfen von Lastkreisen;
Figur 2 einen beispielhaften Ablauf des erfindungsgemäßen Verfahren zum Überprüfen von Lastkreisen eines Steuersystems in einer Anlage.

### Ausführung der Erfindung

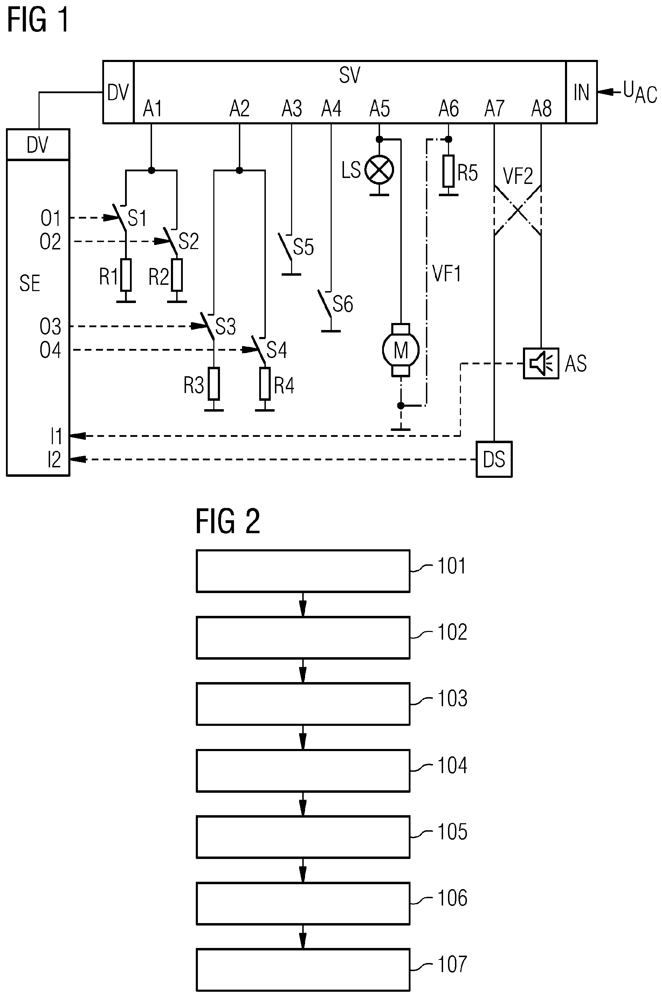

Figur 1 zeigt in schematischer Weise beispielhaft ein Steuersystem einer technischen Anlage. Das beispielhafte Steuersystem umfasst zumindest eine Steuereinheit SE, welche z.B. als speicherprogrammierbare Steuerung (kurz SPS), als Mikrocontroller oder als Industrie-PC ausgeführt sein kann. Die Steuereinheit SE weist beispielsweise zur Ansteuerung von Lasteinheiten - z.B. zum Schalten von Schalteinheiten S1, ..., S4 - Steuerausgänge O1, ..., O4 auf. Alternativ können die Schalteinheiten S1, ..., S4 auch Teil einer Ausgangsbaugruppe der Steuereinheit SE, insbesondere einer digitalen Ausgangsbaugruppe mit einer speicherprogrammierbaren Steuerung bzw. SPS, sein. Die Steuerausgänge O1, ..., O4 der Steuereinheit SE sind z.B. als digitale Ausgänge ausgestaltet. Zusätzlich oder anstatt der digitalen Steuerausgänge O1, ..., O4 kann die Steuereinheit auch analoge Ausgänge aufweisen, an welche z.B. Aktoreinheiten bzw. Schalteinheiten angeschlossen sein können. Die Steuerausgänge O1, ..., O4 dienen dazu mittels Steuersignalen die Anlage bzw. Maschine während des Betriebs anzusteuern und damit in unterschiedliche Betriebs- bzw. Anlagenzustände zu versetzen. Weiterhin weist die Steuereinheit SE z.B. digitale Eingänge I1, I2, auf, über welche z.B. Signale von Lasteinheiten, wie z.B. Sensoreinheiten DS, AS, empfangen werden. Mittels der empfangenen Signale an den Eingänge I1, I2 erhält die Steuereinheit SE Informationen über das aktuelle Geschehen in der Anlage, wodurch entsprechende Steuer- und Regelvorgänge ausgelöst werden können. Die Steuereinheit SE kann auch analoge Eingänge für eine Anbindung und Abfrage von Sensoreinheiten aufweisen.

Weiterhin weist das beispielhafte Steuersystem eine getaktete Stromversorgung SV, welche über eine Eingangsseite IN mit einer Spannungsversorgung U_{AC} (z.B. einer 3-phasigen Wechselspannung) verbunden ist. Weiterhin weist die Stromversorgung z.B. acht Ausgangskanäle A1, ..., A8 auf, an welche die Lastkreise des Steuersystems z.B. direkt angeschlossen sind. Über die Ausgangskanäle A1, ..., A8 werden die Lastkreise des Steuersystems mit einer Versorgungsspannung (z.B. 24 V Gleichspannung) bzw. mit einem Versorgungsstrom von der Stromversorgung SV versorgt. Dabei kann - wie z.B. bei der SITOP PSU8600 - für jeden Ausgangskanal A1, ..., A8 ein Wert der an den jeweiligen Lastkreis gelieferten Versorgungsspannung individuell eingestellt und überwacht werden. Bei dem in Figur 1 beispielhaft dargestellten Steuerungssystem wird beispielsweise die in den jeweiligen Lastkreis gelieferte Versorgungsspannung für den jeweils zugehörigen Ausgangskanal A1, ..., A8 vorgegeben.

Alternativ kann die Stromversorgung SV derart ausgestaltet sein, dass z.B. eine externe Baugruppe (z.B. eine extern schaltbare Sicherungseinheit, etc.) mit zumindest zwei Ausgangszweigen angeschaltet ist. Die zumindest zwei Ausgangskanäle A1, ..., A8 zum Anschließen der Lastkreise werden dann von der externen Baugruppe zur Verfügung gestellt. Dabei sind die Ausgangskanäle A1, ..., A8 z.B. getrennt schaltbar und die jeweiligen Lastkreise werden über diese Ausgangkanäle mit Spannung bzw. Strom versorgt werden, wobei die an den jeweiligen Lastkreis gelieferte Spannung bzw. der Strom individuell einstellbar und überwachbar ist.

Weiterhin können die Stromversorgung SV sowie die Steuereinheit SE Schnittstellenmodule DV aufweisen, über welche eine z.B. bidirektionale Datenverbindung zum Übertragen von Steuersignalen und Dateninformationen hergestellt werden kann. Für die Datenverbindung kann beispielsweise Profinet (Process Field Network) - ein der offene Industrie-Ethernet-Standard der PROFIBUS-Nutzerorganisation - verwendet werden.

Für eine Spannungsversorgung der Steuereinheit SE kann eine eigene Stromversorgung vorgesehen sein, welche in der Figur 1 nicht dargestellt ist. Die Steuereinheit SE kann aber auch direkt von der Stromversorgung SV des Steuersystems mit der entsprechenden Spannung versorgt werden. Dazu kann die Steuereinheit SE z.B. an einen ersten Ausgangskanal A1 der Stromversorgung SV angebunden sein. Der erste Ausgangskanal A1 muss dann während einer Durchführung des Überprüfungsverfahrens immer aktiviert sein, um die Steuereinheit SE mit Spannung bzw. Strom zu versorgen.

An die Ausgangskanäle A1, ..., A8 sind die Lastkreise angeschlossen, welche jeweils zumindest eine Lasteinheit (z.B. Schalteinheit, Aktoreinheit, Sensoreinheit, etc.) aufweisen. Bei dem in Figur 1 beispielhaft dargestellten Steuersystem sind z.B. am ersten Ausgangskanal A1 und an einem zweiten Ausgangskanal A2 Schalteinheiten S1, S2, S3, S4 sowie zugehörige Lastwiderstände R1, R2, R3, R4 (z.B. Schütze) angebunden. Die jeweiligen Schalteinheiten S1, S2, S3, S4 sind mittels entsprechender Signale auf den jeweiligen Steuerausgängen O1, O2, O3, O4 zu- oder wegschaltbar. An einen dritten und vierten Ausgangskanal A3, A4 sind z.B. weitere Aktor- bzw. Schalteinheiten S5, S6 (z.B. Schütze, Magnetventile, etc.) als Lasteinheiten angebunden. Über diese Schalteinheiten S5, S6 sind zum Ein- bzw. Ausschalten eines elektrischen Ventils, eines Motors oder eines Moduls für eine Antriebssteuerung, etc. von der Steuereinheit SE ansteuerbar.

An einem fünften Ausgangskanal A5 ist z.B. ein Lichtsignal LS sowie ein Motor M z.B. zum Betreiben einer Lüftereinheit angeschlossen. An einem sechsten Ausgangskanal A6 ist z.B. ein weiterer Lastwiderstand R5 angebunden. Dabei ist beispielsweise der Motor M bzw. die Lüftereinheit fälschlicherweise nicht vom fünften Ausgangskanal A5 gegen Masse - wie mittels strichlierter Linie dargestellt - geschaltet, sondern aufgrund eines ersten Verdrahtungsfehlers VF1 (z.B. beim Aufbau der Anlage bzw. der Maschine) mit dem sechsten Ausgangskanal A6 verbunden. Der erste Verdrahtungsfehler VF1 ist dabei als strich-punktierte Linie dargestellt.

An einem siebten und an einem achten Ausgangskanal A7, A8 sind z.B. Lastkreise angebunden, welche als Lasteinheiten z.B. Sensoreinheiten DS, AS, wie z.B. ein Drucksensor DS, eine akustische Signaleinheit AS, etc. aufweisen. Von den Sensoreinheiten DS, AS werden jeweils Signale an die digitalen Eingänge I1, I2 der Steuereinheit SE geliefert. Bei diesen Lastkreisen ist ein zweiter beispielhafter Verdrahtungsfehler VF2 dargestellt, durch welchen eine Anschaltung der Sensoreinheiten DS, AS an die jeweiligen Ausgangskanäle A7, A8 vertauscht ist - wieder mittels strich-punktierter Linie dargestellt. Die korrekte Verdrahtung ist mittels strichlierter Linie in Figur 1 dargestellt. Durch den zweiten Verdrahtungsfehler VF2 wird die akustische Signaleinheit AS über den siebenten Ausgangskanal A7 und der Drucksensor DS über den achten Ausgangskanal A8 Spannung versorgt. Die jeweiligen Signalausgänge des Drucksensors DS bzw. der akustischen Signaleinheit AS sind jedoch mit den jeweils korrekten digitalen Eingängen I1, I2 der Steuereinheit SE verbunden, wodurch z.B. der Drucksensor DS ab Erreichen eines Schwellwerts ein Eingangssignal an den digitalen Eingang I2 der Steuereinheit SE meldet, und die akustische Signaleinheit AS während des Betriebs ein Funktionssignal an den digitalen Eingang I1 der Steuereinheit SE abgibt.

Die Figur 2 zeigt beispielhaft einen Ablauf des erfindungsgemäßen Verfahrens zum Überprüfen von Lastkreisen eines Steuersystems einer Anlage, wie beispielhaft in Figur 1 dargestellt.

In einem Definitionsschritt 101 werden Anlagenzustände für die Überprüfung der Lastkreis des Anlagen-Steuersystems vorgegeben. Ein Anlagenzustand stellt einen Betriebszustand der Anlage bzw. des Steuersystems dar, welcher über eine Schalterstellung durch die Steuereinheit SE und aktivierte - d.h. mit Versorgungsspannung versorgte - Lastkreise definiert bzw. hervorgerufen wird. D.h. für einen Anlagenzustand wird je nach den von Steuereinheit SE zur Verfügung gestellten Signalen z.B. einer oder mehrere Ausgangskanäle A1, ..., A8 und damit die jeweils angeschlossene Lastkreise aktiv geschaltet und/oder über die Steuerausgänge O1, ..., O4 die jeweilige Lasteinheiten in den Lastkreisen zu- oder weggeschaltet. Bei einem vorgegebenen Anlagenzustand ist daher zumindest ein Ausgangskanal A1, ..., A8 und/oder ein Steuerausgang O1, ..., O4 eingeschaltet. Die jeweiligen Anlagenzustände und damit die jeweils ein- und ausgeschalteten Ausgangskanäle A1, ..., A8 sowie die jeweils ein- und ausgeschalteten Steuerausgänge O1, ..., O4 werden durch die Steuereinheit SE vorgegeben. Die Steuereinheit SE kann dadurch zumindest eine Mehrzahl der Lasteinheiten gezielt aktivieren und deaktivieren und damit sehr einfach die vorgegebenen Anlagenzustände herstellen. Ein Ansteuerung der Ausgangskanäle A1, ..., A8 der Stromversorgung SV kann dabei z.B. über die Datenverbindung DV zwischen der Steuereinheit SE und der Stromversorgung SV erfolgen.

Weiterhin werden die für das Verfahren vorgegeben Anlagenzustände im Definitionsschritt 101 zumindest in Basiszustände und Kombinationszustände unterteilt. Ein Basiszustand stellt einen Anlagenzustand dar, bei welchem zumindest ein Ausgangskanal A1, ..., A8 oder ein Steuerausgang O1, ..., O4 der Steuereinheit aktiv geschaltet oder eingeschaltet ist. Für das in Figur 1 beispielhaft dargestellte Steuersystem können z.B. Anlagenzustände, bei welchen der erste, der zweite, der dritte, etc. Ausgangskanal A1, ..., A8 allein und damit der jeweils zugehörige Lastkreis aktiviert ist, als Basiszustände festgelegt werden. Die restlichen Ausgangskanäle A1, ..., A8 bleiben dabei abgeschaltet. Weiterhin kann das Einschalten eines der Steuerausgänge O1, ..., O4 und damit z.B. das Einschalten der jeweils angesteuerten Schalteinheit S1, S2, S3, S4 bzw. das Zuschalten der jeweiligen Lasteinheit R1, R2, R3, R4 einen Basiszustand darstellen. Weiterhin kann auch eine z.B. gleichzeitige Aktivierung von mehreren Ausgangskanälen A1, ..., A8 und/oder mehrere Steuerausgängen O1, ..., O4 als Basiszustand festgelegt werden. Bei dem in Figur 1 dargestellten Steuersystem einer Anlage kann beispielsweise eine gleichzeitige Aktivierung eines ersten Steuerausgangs O1 und eines zweiten Steuerausgangs O2 der Steuereinheit SE zusätzlich zum eingeschalteten ersten Ausgangskanal A1 als Basiszustand definiert werden. Dabei werden dann beispielsweise die zugehörigen Schaltelemente S1, S2 im an den ersten Ausgangskanal A1 der Stromversorgung SV angeschlossenen Lastkreis geschaltet und die zugehörigen Lastwiderstände R1, R2 gleichzeitig zugeschaltet. Analog können z.B. auch die Anlagenzustände für den zweiten Ausgangskanal A2 der Stromversorgung SV z.B. zusammengefasst werden und als Basiszustand festgelegt werden.

Unter einem Kombinationszustand wird dann eine Kombination aus zumindest zwei Anlagenzuständen, welche als Basiszustände festgelegt sind, verstanden. D.h. bei dem in Figur 1 dargestellten Steuersystem kann z.B. das Einschalten des ersten Ausgangskanal A1 als erste Basiszustand sowie das Einschalten des ersten Steuerausgangs O1 als zweiter Basiszustand vorgegeben werden. Ein Kombinationszustand wäre dann, wenn z.B. zuerst als erste Anlagenzustand bzw. erster Basiszustand der erste Ausgangskanal A1 aktiviert wird und dann zum ersten Anlagenzustand bzw. ersten Basiszustand der erste Steuerausgang O1, dessen alleinige Aktivierung den zweiten Basiszustand bildet, für einen folgenden Anlagenzustand - d.h. Kombinationszustand - zusätzlich dazu aktiv geschaltet wird.

Bei realen Anlagen können wesentlich mehr Anlagenzustände, welche dann je nach Bedarf als Basis- oder Kombinationszustande festgelegt werden, definiert und für das Verfahren verwendet werden. Dabei sollten allerdings im Definitionsschritt 101 nicht zielführende, gefährliche oder nicht sinnvolle Anlagenzustände (z.B. ein Anlagenzustand, durch welchen eine Pumpe ein Antrieb oder ein Ventil ungewollt aktiviert wird) ausgeschlossen werden. Weiterhin können die vorgegebenen bzw. als sinnvoll erachteten Anlagenzustände in Form eines Testprogramm zusammengefasst werden, welches z.B. für eine Selbsttestphase einer Anlage, welche in Betrieb genommen wird, angepasst werden kann - d.h. die Anlagenzustände können anlagen- und/oder benutzerspezifisch ausgewählt und vorgegeben werden.

Weiterhin wird im Definitionsschritt 101 für jeden vorgegebenen Anlagenzustand ein Satz entsprechender, zu ermittelnde Parameter vorgegeben. Je nach vorgegebenen Anlagenzustand können als Parameter z.B. Spannung und/oder Strom an einem oder mehreren Ausgangskanälen A1, ..., A8 und/oder Signalwerte an zumindest einem Steuerausgänge O1, ..., O4 der Steuereinheit SE abgefragt werden. Zusätzlich können für vorgegebene Anlagenzustände auch die Eingänge I1, I2 der Steuereinheit SE z.B. auf anstehende Signalwerte von Sensoreinheiten DS, AS abgefragt werden. Derartige Inputs (z.B. Temperaturwerte, Drehzahlwerte, Dampfdruckwerte, Funktionssignale, etc.) können beispielsweise zusätzlich genutzt werden, um Lastkreis - insbesondere eine korrekte Verdrahtung einer Sensoreinheit DS, AS - zu überprüfen.

Weiterhin können für jeden der vorgegebenen Anlagenzustände, insbesondere für jene Anlagenzustände, bei welchen zumindest ein Ausgangskanal A1, ..., A8 der Stromversorgung aktiviert ist, mehrere Spannungswerte vorgegebenen werden. Die unterschiedlichen Spannungswerte können dem jeweiligen Ausgangskanal A1, ..., A8 beispielsweise für den jeweiligen Anlagenzustand von der Steuereinheit SE vorgegeben werden oder gegebenenfalls am extern angeschalteten Ausgangszweig eingestellt werden. Jeder vorgegebenen Spannungswert der Versorgungsspannung bildet mit dem zugehörigen Anlagenzustand einen eigenen, neuen Anlagenzustand, wobei eine Änderung der Versorgungsspannung an der Unterteilung in Basis- und Kombinationszustände nicht verändert. Alternativ können anstatt Spannungswerten auch mehrere Stromwerte vorgegeben werden, wobei jeder vorgegebene Stromwert mit dem zugehörigen Anlagenzustand einen eigenen Anlagenzustand bildet.

Für eine Überprüfung der Lastkreise gemäß dem Verfahren werden in einem Referenzschritt 102 Referenzwerte der Parameter der einzelnen im Definitionsschritt 101 vorgegebenen Anlagenzustände ermittelt. D.h. es wird z.B. mit Hilfe der Steuereinheit SE ein vorgegebener Anlagenzustand (z.B. ein erster Anlagenzustand mit eingeschaltetem ersten Ausgangskanal A1 der Stromversorgung SV; ein zweiter Anlagenzustand mit aktiviertem ersten digitalen Ausgang O1 der Steuereinheit SE; usw.) hervorgerufen. Die Abfolge der Anlagenzustände kann im Referenzschritt 102 beliebig - idealerweise nach Effizienzkriterien - gewählt werden. Dann werden die Referenzwerte für die zum Anlagenzustand vorgegebenen Parameter ermittelt - z.B. die Spannung und/oder der Strom am eingeschalteten Ausgangskanal A1 und gegebenenfalls an den ausgeschalteten Ausgangskanälen A2, ..., A8 gemessen, Signalwerte von Steuerausgänge O1, ..., O4 und/oder Eingängen I1, I2 der Steuereinheit abgefragt. Die ermittelten Referenzwerte werden dann gemeinsam mit dem jeweiligen Anlagenzustand abgespeichert.

Wurden für einen Anlagenzustand im Definitionsschritt 101 mehrere Spannungswerte für die Versorgungsspannung des zumindest einen aktivierten Ausgangskanal A1, ..., A8 (oder Stromwerte) vorgegeben. So werden im Referenzschritt 102 von der Steuereinheit SE z.B. der jeweilige Spannungswert (oder Stromwert) für den zumindest einen Ausgangskanal A1, ..., A8 vorgegeben bzw. extern eingestellt und der jeweilige Anlagenzustand hervorgerufen. Dann werden die Referenzwerte der Parameter des jeweiligen Anlagenzustands und des jeweiligen Spannungswerts (bzw. Stromwerts) ermittelt. Für jeden vorgegebenen Spannungswert (bzw. Stromwert) wird der Anlagenzustand mit zugehörigen, ermittelten Referenzwerten und mit dem vorgegebenen, eingestellten Spannungswert (bzw. Stromwert) als eigener Anlagenzustand abgespeichert.

Bei einer Änderung von einem vorgegebenen Anlagenzustand auf den einen weiteren vorgegebenen Anlagenzustand kann bei der Ermittlung der Referenzwerte beispielsweise eine vorgegebene Wartezeit vorgesehen sein. Insbesondere wenn die vorgegebene Spannung der Versorgungsspannung am zumindest einen eingeschalteten Ausgangskanal A1, ..., A8 verändert wird (z.B. mehrere vorgegebene Spannungswerte für einen Anlagenzustand durchlaufen werden), kann es sinnvoll sein, zwischen dem Ändern des Spannungswerts der Versorgungsspannung und dem Ermitteln der Referenzwerte, insbesondere beim Messen von Stromwerten im zumindest einen eingeschalteten Ausgangskanal A1, ..., A8 der Stromversorgung SV, eine vorgegebene Wartezeit einzuhalten. Auf diese Weise werden z.B. Stromschwankungen durch Einschwingvorgänge aufgrund der Spannungsänderung, etc. nicht mitgemessen, sondern ein möglichst statischer bzw. konstanter aktueller Parameterwerte, insbesondere Stromwerte, gemessen.

Die Referenzwerte und gegebenenfalls nötige bzw. sinnvolle Wartezeiten können im Referenzschritt 102 beispielsweise mittels einer Referenzanlage z.B. von einem Hersteller in einer Entwicklungstestphase (d.h. nach erfolgter Entwicklung z.B. einer Serienanlage) vorgenommen werden. Alternativ oder zusätzlich, können z.B. bei benutzerspezifischen Anlagen oder Maschinen die Referenzwerte und gegebenenfalls die Wartezeiten während einer erstmaligen Inbetriebnahme der Anlage oder Maschine ermittelt oder aus Messwerten abgeleitet werden, welche während des laufenden Betriebs für die vorgegebenen Anlagenzustände gemessen werden. Die Anlagenzustände können mit den für die zugehörigen Parameter ermittelten Referenzwerten z.B. in der Steuereinheit SE der Anlage gespeichert werden, auf eine Steuereinheit SE einer typgleichen Anlage und/oder auf eine z.B. zentral verfügbare Datenverarbeitungseinheit (z.B. Rechnereinheit, Industrie-PC, etc.) übertragen und dort abgespeichert werden.

Auf einer Anlage kann vor der Inbetriebnahme z.B. nach einem Transport und Wiederinstallation, einer Erweiterung oder einer Neuinstallation der jeweiligen Anlage oder auch bei einem Neustart während des laufenden Betriebs der Anlage eine Selbsttestphase durchgeführt werden. Dabei werden in einem Messschritt 103 von der Steuereinheit SE z.B. mittels Befehlen über die Datenverbindung DV an die Stromversorgung SV und gegebenenfalls mittels Signalen an den Steuerausgängen O1, ..., O4 der Steuereinheit SE angebundenen Lasteinheiten S1, ..., S4 gezielt die vorgegebenen Anlagenzustände hervorgerufen. Dabei ist es wichtig, dass die vorgegebenen Anlagenzustände in derselben Reihenfolge durchlaufen wird, wie die Anlagenzustände beim Ermitteln der Referenzwerte im Referenzschritt 102.

Die vorgegebenen Anlagenzustände können beispielweise im Definitionsschritt 101 aus möglichen bzw. für die Anlage sinnvollen Anlagenzuständen ausgewählt und in Basiszustände und Kombinationszustände eingeteilt werden. Vor oder während des Referenzschritts 102 kann beispielsweise eine Liste der vorgegebenen Basis- und Kombinationszustände erstellt und z.B. in der Steuereinheit SE oder in der Datenverarbeitungseinheit abgelegt werden. Diese Liste kann z.B. im Messschritt 103 abgearbeitet werden, um dieselbe Reihenfolge der Anlagenzustände wie im Referenzschritt 102 einzuhalten.

Weiterhin werden auch im Messschritt 103 für einen Anlagenzustand mehrere Spannungswerte der Versorgungsspannung (oder Stromwerte) am jeweils zumindest einen eingeschalteten Ausgangskanal A1, ..., A8 der Stromversorgung eingestellt (z.B. durch die Stromversorgung SV über einen Befehl der Steuereinheit SE), sofern für diesen Anlagenzustand im Definitionsschritt 101 mehrere Spannungswerte (oder Stromwerte) vorgegeben wurden. Um die vorgegebenen Spannungswerte der Versorgungsspannung für den jeweils aktuell vorgegebenen Anlagenzustand im Messschritt 103 zu durchlaufen, kann beispielsweise die Versorgungsspannung ausgehend von einer Ausgangsversorgungsspannung (z.B. 0 Volt) in vorgegebenen Spannungsschritten (z.B. 2 Volt) bis zu einer vorgegebenen Nennspannung (z.B. 24 oder 28 Volt) angehoben werden. Die vorgegebenen Spannungswerte (oder Stromwerte) eines Anlagenzustands in vorgegebenen Spannungsschritten (oder Stromschritten) können analog dem Referenzschritt 102 zur Ermittlung der Referenzwerte durchlaufen werden.

Für jeden vorgegebenen Anlagenzustand und gegebenenfalls jeden für den Anlagenzustand vorgegebenen Spannungswert (oder Stromwerte) werden dann die aktuellen Parameterwerte der zum

Anlagenzustand zugehörigen Parameter gemessen oder abgefragt. D.h. es werden z.B. für den jeweiligen Anlagenzustand bei einem vorgegebenen Spannungsniveau ein aktueller Stromwert und/oder Spannungswert an dem zumindest einen Ausgangskanal A1, ..., A8 und/oder den weiteren Ausgangskanälen gemessen und/oder Signalwerte an den Steuerausgängen und/oder den Eingängen der Steuereinheit SE abgefragt. Dabei ist weiterhin zu beachten, dass im Messschritt 103 ebenfalls die vorgegebene Wartezeit bei einer Änderung von einem Anlagezustand auf einen weiteren Anlagenzustand eingehalten wird, wenn beim Ermitteln der Referenzwerte im Referenzschritt 102 eine vorgegebene Wartezeit vorgesehen war. Die im aktuell laufenden Messschritt 103 ermittelten Parameterwerte werden dann gemeinsam mit dem jeweiligen Anlagenzustand inklusive dem vorgegebenen Spannungswerten, sofern für den jeweiligen Anlagenzustand mehrere Spannungswerte im Definitionsschritt 101 festgelegt wurden, abgespeichert und können dann im Bezug auf die entsprechenden Referenzwerte in einem Vergleichsschritt 104 bewertet werden. Ein Abspeichern der aktuell ermittelten Parameterwerte gemeinsam mit den zugehörigen Anlagenzuständen kann z.B. ebenfalls in der Steuereinheit SE erfolgen, welche dann beispielsweise auch eine Auswertung durchführt. Die aktuell ermittelten Parameterwerte sowie die jeweils zugehörigen Anlagenzustände können für eine weitere Auswertung aber auch an eine Datenverarbeitungseinheit übertragen und dort abgespeichert werden.

Im Vergleichsschritt 104, welcher auch eine erste Filterung der ermittelten Parameterwerte darstellt, werden die aktuell ermittelten Parameterwerte jedes vorgegebenen Anlagenzustands mit den entsprechenden, im Referenzschritt 102 ermittelten Referenzwerten verglichen. Dabei kann der Vergleich in einer beliebigen Reihenfolge erfolgen. Beim Vergleich zwischen einem jeweiligen aktuell ermittelten Parameterwert eines vorgegebenen Anlagenzustands und dem entsprechenden Referenzwert desselben Anlagenzustands wird geprüft, ob der jeweilige aktuell ermittelte Parameterwert vom entsprechenden Referenzwert abweicht oder nicht. Wird beim Vergleich eine Abweichung feststellt, so wird der jeweilige Parameterwert gemeinsam mit jenem Anlagenzustand und gegebenfalls vorgegebenen Spannungswert, bei welchen der Parameterwert ermittelt wurde, in einem Speicherschritt 105 als Element in einer Abweichliste gespeichert. Daraufhin wird z.B. entweder der nächste, aktuell ermittelte Parameterwert des jeweiligen Anlagenzustands oder ein erster aktuell ermittelter Parameterwert eines nächsten Anlagenzustands verglichen. Gibt es keine Abweichung zwischen einem jeweiligen Parameterwert und dem entsprechenden Referenzwert eines jeweiligen Anlagenzustands, so wird entweder der nächste, aktuell ermittelte Parameterwert des jeweiligen Anlagenzustands oder ein erster aktuell ermittelter Parameterwert eines nächsten Anlagenzustands überprüft, bis alle aktuell ermittelten Parameterwerte mit den entsprechenden Referenzwerten verglichen wurden.

Beim Vergleich zwischen aktuell gemessenen Parameterwerten und den entsprechenden Referenzwerten kann beispielsweise ein Toleranzbereich vorgegeben werden. Dann wird beispielsweise geprüft, ob beim Vergleichen des jeweiligen, aktuell ermittelten Parameterwert mit dem entsprechenden Referenzwert der vorgegebener Toleranzbereich überschritten wird oder nicht. In der Abweichliste werden dann im Speicherschritt 105 nur jene aktuell ermittelten Parameterwert gemeinsam mit dem zugehörigen Anlagenzustand als Element gespeichert, wenn beim Vergleich mit dem entsprechenden Referenzwert der Toleranzbereich verlassen wird.

Der vorgegebene Toleranzbereich kann dabei z.B. in Form eines Prozentsatzes oder in Form eines Absolutbereichs angegeben sein. Es kann dabei ein Toleranzbereich für alle zu prüfenden Lastkreise der Anlage bzw. Maschine vorgesehen werden. Es ist allerdings auch möglich, lastkreisspezifisch individuell Toleranzbereiche vorzugeben oder Toleranzbereiche für z.B. gleich oder ähnlich ausgeführte Lastkreise vorzusehen. Weiterhin kann der Toleranzbereich angepasst werden, wenn z.B. bei mehrmaliger Anwendung erkannt wird, dass der vorgegebene Toleranzbereich z.B. zu eng oder zu weit gewählt worden ist.

Nachdem alle aktuell ermittelten Parameterwerte im Vergleichsschritt 104 geprüft wurden und die abweichenden Parameterwerte mit den jeweils zugehörigen Anlagenzuständen im Speicherschritt 105 in der Abweichliste gespeichert sind, werden redundante Informationen (d.h. Elemente aus aktuell ermittelten Parameterwert und zugehörigem Anlagenzustand) in einem Filterschritt 106 auf Basis der Unterteilung der Anlagenzustände in Basiszustände und Kombinationszustände aus der Abweichliste gefiltert.

Dazu wird für jedes Element der Abweichliste geprüft, ob der Anlagenzustand des jeweiligen Elements ein Basiszustand oder ein Kombinationszustand ist. Auch die Überprüfung der Elemente der Abweichliste kann in einer beliebigen Reihenfolge erfolgen. Ist der Anlagenzustand des jeweiligen Elements ein Basiszustand, dann wird das jeweilige Element (d.h. Parameterwert und Anlagenzustand) in eine Ergebnisliste übertragen. Ist der Anlagenzustand des jeweiligen Elements ein Kombinationszustand, dann wird weiterhin geprüft, ob die Abweichliste zumindest ein Element mit einem jener Basiszustände als Anlagenzustand aufweist, aus welchen der Kombinationszustand zusammengesetzt ist. Wird kein derartiges Element in der Abweichliste gefunden, so wird das jeweilige Element (d.h. Parameterwert und Anlagenzustand) in die Ergebnisliste übertragen. Wird in der Abweichliste zumindest ein Element gefunden, welches einen jener Basiszustände aufweist, aus welchen sich der Kombinationszustand des jeweiligen, gerade überprüften Element zusammensetzt, so werden die ermittelten Parameterwerte der Elemente verglichen. Das jeweilige, gerade überprüfte Element (d.h. Parameterwert und Anlagenzustand) wird nur dann in die Ergebnisliste übertragen, wenn sein Parameterwert wertmäßig (d.h. der ermittelte Parameterwert) oder typmäßig (d.h. der Typ des zu ermittelnden Parameters, wie z.B. Spannung, Strom, Temperatur, Sensorwert, Signalwert, etc.) vom Parameterwert des zumindest einen gefundenen Elements abweicht. D.h. stimmen die Parameterwerte des jeweiligen, gerade überprüften Element und jenes zumindest einen gefundenen Elements mit einem jener Basiszustände, aus welchen sich der Kombinationszustand des jeweiligen, gerade überprüften Element zusammensetzt, in Parameterwert und Parametertyp überein, so wird die Information des jeweiligen, gerade überprüften Element als redundant bewertet und dieses Element nicht in die Ergebnisliste übertragen bzw. ausgefiltert.

Weiterhin können im Filterschritt 106 jene Elemente der Ergebnisliste, welche als Anlagenzustand einen Basiszustand aufweisen, überprüft werden, ob bei diesen Elementen aktuell ermittelte Parameterwerte vorkommen, welche wertmäßig und typmäßig übereinstimmen. D.h. die Ergebnisliste wird darauf überprüft, ob bei allen Elementen der Ergebnisliste mit einem Basiszustand als Anlagenzustand ein bestimmter Parameterwert vorkommt, welcher denselben Wert und denselben Parametertyp (z.B. Spannung an einem Ausgangskanal, Strom an einem Ausgangskanal, Signalwert an einem Steuerausgang oder Eingang, etc.) aufweist. Dieser Parameterwert wird dann im Filterschritt 106 aus der Ergebnisliste gefiltert. Wird kein weiterer abweichender Parameterwert zu diesem Basiszustand in der Ergebnisliste gefunden, so wird das entsprechende Element (d.h. der jeweilige Parameter und der jeweils zugehörige Anlagenzustand) aus der Ergebnisliste gefiltert. Am Ende der Ergebnisliste kann z.B. ein Verweis auf diesen Parameterwert bzw. das jeweilige Element eingefügt werden.

In einem Ausgabeschritt 107 kann dann die Ergebnisliste für eine Weiterverarbeitung weitergeleitet und/oder ausgegeben werden. Dabei können Elemente der Ergebnisliste mit identen Anlagenzuständen zusammengefasst werden. D.h. im Ausgabeschritt 107 wird z.B. die Ergebnisliste als Textdatei ausgegeben, in welcher z.B. die jeweiligen Anlagenzustände mit den jeweils abweichenden Parametern mit ermittelten Parameterwert und Parametertyp angeführt sind. Die Textdatei kann dann z.B. in einer Datenverarbeitungseinheit (z.B. Recheneinheit, Industrie-PC) oder manuell von einem Anwender ausgewertet werden. Alternativ kann die Ergebnisliste z.B. derart ausgewertet und aufbereitet werden, dass dem Anwender beispielsweise über eine Anzeige jene Lastkreise des Steuersystems der Anlage angezeigt werden, in welchen abweichende Parameterwerte ermittelt wurden. Bei der in Figur 1 beispielhaft dargestellten Anlage würden dann beispielsweise die Lastkreise, welche am fünften und sechsten Ausgangskanal A5, A6 angeschlossen sind und den ersten Verdrahtungsfehler VF1 aufweisen und welche am siebenten und achten Ausgangskanal A7, A8 und den zweiten Verdrahtungsfehler VF2 aufweisen, angezeigt werden. In der Ergebnisliste wären als Element jene Anlagenzustände mit entsprechenden Parameterwerten zu finden, welche beim Durchlauf des Verfahrens als abweichend erkannt wurden und deren Informationsgehalt für das Auffinden der Verdrahtungsfehler VF1, VF2 eindeutig ist.

Das anhand der Figuren beschriebene Verfahren kann auch für Testverfahren von Anlagen mit einem reduzierten Satz an vorgegebenen Anlagenzuständen angewandt werden. D.h. es können zum Überprüfen der Lastkreise - z.B. als Test während des laufenden Betriebs, um z.B. defekte Bauteile, Leitungsbrüche, etc. rascher zu finden, einige, für die jeweilige Anlage sinnvolle Anlagenzustände vorgegeben werden und das Verfahren durchlaufen werden.

Weiterhin besteht die Möglichkeit das Verfahren anzuwenden, um einen sinnvoll reduzierten Satz von Anlagenzuständen für eine reduzierte und zeitlich effiziente Überprüfung der Anlage zu ermitteln. Dazu erfolgt im Referenzschritt 101 bei der Messung der Referenzwerte vor jedem der jeweiligen Anlagenzustände eine so genannte Leermessung der Parameter der jeweiligen Anlagenzustände. D.h. für die Parameter des jeweiligen Anlagenzustands werden an der ruhenden Anlage Leerwerte der Parameter gemessen, bevor der jeweilige Anlagenzustand von der Steuereinheit SE hervorgerufen wird. Im Vergleichsschritt 104 werden dann für jeden Anlagenzustand die gemessen Leerwerte mit den ermittelten Referenzwerten verglichen und auf die ermittelte Abweichliste der Filterschritt 106 angewendet. Dadurch können für die Überprüfung der Anlage relevante Anlagenzustände erkannt werden und damit ein reduzierter Satz von Anlagenzuständen für das Verfahren ermittelt werden.

## Patentansprüche

1. Computerimplementiertes Verfahren zum Überprüfen von Lastkreisen eines Steuersystems einer Anlage, welches zumindest eine Steuereinheit (SE), eine Stromversorgung (SV) sowie zumindest zwei Lastkreise mit jeweils zumindest einer Lasteinheit aufweist, wobei die zumindest zwei Lastkreise von der Stromversorgung (SV) über zumindest zwei Ausgangskanäle (A1 bis A8) mit einer Versorgungsspannung und/oder einem Versorgungsstrom versorgt werden, welche in Spannungs- und/oder Stromhöhe variierbar sind, und wobei von der Steuereinheit (SE) die zumindest zwei Ausgangskanäle (A1 bis A8) sowie Steuerausgänge (O1 bis O4) der Steuereinheit (SE) angesteuert werden und dadurch Anlagenzustände hervorgerufen werden, folgende Schritte aufweisend:
- Vorgeben von Anlagenzustände, wobei die Anlagenzustände zumindest in Basiszustände und Kombinationszustände unterteilt werden, wobei jedem Anlagenzustand zu ermittelnde Parameter zugeordnet werden (101), wobei ein Basiszustand ein Anlagenzustand ist, bei welchem:
i) zumindest ein Ausgangskanal (A1 bis A8) oder ein Steuerausgang (O1 bis O4) der Steuereinheit aktiv geschaltet oder eingeschaltet ist, oder
ii) mehrere Ausgangskanäle (A1 bis A8) und/oder mehrere Steuerausgänge (O1 bis O4) gleichzeitig aktiviert sind,
und wobei ein Kombinationszustand eine Kombination aus zumindest zwei Anlagenzuständen ist, welche als Basiszustände festgelegt sind;
- Ermitteln und Abspeichern von Referenzwerten der Parameter für die jeweils vorgegebenen Anlagenzustände (102);
- Ermitteln und Abspeichern von aktuellen Parameterwerten für die jeweils vorgegebenen Anlagenzustände (103);
- Vergleichen der aktuell ermittelten Parameterwerte mit den entsprechenden Referenzwerten (104), wobei jene ermittelten Parameterwerte mit dem jeweils zugeordneten Anlagenzustand als Elemente in einer Abweichliste gespeichert werden (105), welche von den entsprechenden Referenzwerten abweichen;
- Filtern der Abweichliste (106), wobei für jedes Element der Abweichliste geprüft wird, ob der Anlagenzustand des jeweiligen Elements ein Basiszustand oder ein Kombinationszustand ist;
wobei das jeweilige Element in eine Ergebnisliste übertragen wird, wenn der Anlagenzustand des jeweiligen Elements ein Basiszustand ist;
wobei geprüft wird, ob die Abweichliste zumindest ein Element mit einem jener Basiszustände aufweist, aus welchen der Kombinationszustand des jeweiligen Elements zusammengesetzt ist, wenn der Anlagenzustand des jeweilige Elements ein Kombinationszustand ist;
wobei das jeweilige Element in die Ergebnisliste übertragen wird, wenn in der Abweichliste kein derartiges Element gefunden wird;
und wobei nach Finden von zumindest einem Element mit einem jener Basiszustände, aus welchen der Kombinationszustand des jeweiligen Elements zusammengesetzt ist, in der Abweichliste der ermittelte Parameterwert des jeweiligen Elements mit dem ermittelten Parameter des zumindest einen gefundenen Elements verglichen wird und das jeweilige Element in die Ergebnisliste übertragen wird, wenn der ermittelte Parameterwert des jeweiligen Elements wertmäßig oder typmäßig vom ermittelten Parameterwert des zumindest einen gefundenen Elements abweicht.

2. Verfahren nach Anspruch 1, ***dadurch gekennzeichnet, dass*** jene Elemente der Ergebnisliste, welche als Anlagenzustand einen Basiszustand aufweisen, überprüft werden (106), ob bei diesen Elementen ermittelte Parameterwerte angeführt sind, welche wertmäßig und typmäßig übereinstimmen.

3. Verfahren nach einem der Ansprüche 1 bis 2, ***dadurch gekennzeichnet, dass*** die Ergebnisliste für eine Weiterverarbeitung weitergeleitet und/oder ausgegeben wird (107), wobei Elemente der Ergebnisliste mit identen Anlagenzustände zusammengefasst werden.

4. Verfahren nach einem der Ansprüche 1 bis 3, ***dadurch gekennzeichnet, dass*** als zu ermittelnde Parameter in Abhängigkeit vom jeweiligen Anlagenzustand zumindest eine Spannung an zumindest einem der zumindest zwei Ausgangskanäle (A1 bis A8), ein Strom an zumindest einem der zumindest zwei Ausgangskanäle (A1 bis A8), ein Signal an zumindest einem Steuerausgang (O1 bis O4) der Steuereinheit (SE) und/oder ein Signal an zumindest einem Eingang (I1, I2) der Steuereinheit (SE) vorgegeben werden (101).

5. Verfahren nach einem der vorangegangenen Ansprüche, ***dadurch gekennzeichnet, dass*** beim Ermitteln der Referenzwerte und beim Ermitteln der aktuellen Parameterwerte die vorgegebenen Anlagenzustände in derselben Reihenfolge durchlaufen werden (102, 103).

6. Verfahren nach einem der vorangegangenen Ansprüche, ***dadurch gekennzeichnet, dass*** den vorgegebenen Anlagenzuständen mehrere Spannungswerte für die Versorgungsspannung vorgegeben werden (101).

7. Verfahren nach Anspruch 6, ***dadurch gekennzeichnet, dass*** die vorgegebenen Spannungswerte in vorgegebenen Spannungsschritten von einer Ausgangsversorgungsspannung bis zu einer Nennspannung oder bis zu einer Betriebsgrenze der zumindest einen an den jeweiligen Lastkreis angeschlossenen Lasteinheit angehoben werden (102, 103).

8. Verfahren nach einem der vorangegangenen Ansprüche, ***dadurch gekennzeichnet, dass*** beim Ermitteln der Referenzwerte und beim Ermitteln der aktuellen Parameterwerte bei einer Änderung von einem vorgegebenen Anlagenzustand auf einen weiteren vorgegebenen Anlagenzustand eine vorgebbare Wartezeit eingehalten wird (102, 103).

9. Verfahren nach einem der vorangegangenen Ansprüche, ***dadurch gekennzeichnet, dass*** die Referenzwerte der vorgegebenen Parameter für die vorgegebenen Anlagenzustände mittels einer Referenzanlage ermittelt werden (102).

10. Verfahren nach einem der Ansprüche 1 bis 8, ***dadurch gekennzeichnet, dass*** die Referenzwerte der vorgegebenen Parameter für die vorgegebenen Anlagenzustände während einer Inbetriebnahme der zu überprüfenden Anlage oder während eines laufenden Betriebs der zu überprüfenden Anlage abgeleitet werden (102).

## Claims

1. Computer-implemented method for checking load circuits of a control system of an installation, said control system comprising at least one control unit (SE), a power supply (SV) and at least two load circuits, each having at least one load unit, wherein the at least two load circuits are supplied with a supply voltage and/or a supply current by the power supply (SV) via at least two output channels (A1 to A8) with variable voltage and/or current level, and wherein the at least two output channels (A1 to A8) and control outputs (O1 to O4) of the control unit (SE) are controlled by the control unit (SE), thereby producing installation states, said method comprising the following steps:
- predefining installation states, wherein the installation states are subdivided at least into basic states and combination states, wherein parameters to be determined are assigned to each installation state (101), wherein a basic state is an installation state, in which:
i) at least one output channel (A1 to A8) or a control output (O1 to O4) of the control unit is switched active or switched on, or
ii) a plurality of output channels (A1 to A8) and/or a plurality of control outputs (O1 to O4) are activated simultaneously,
and wherein a combination state is a combination of at least two installation states, which are specified as basic states;
- determining and storing reference values of the parameters for the respective predefined installation states (102);
- determining and storing present parameter values for the respective predefined installation states (103);
- comparing the currently determined parameter values with the corresponding reference values (104), wherein those determined parameter values with the respectively assigned installation state which deviate from the corresponding reference values are stored (105) as elements in a divergence list;
- filtering the divergence list (106), wherein for each element of the divergence list a check is performed to ascertain whether the installation state of the respective element is a basic state or a combination state; wherein the respective element is transferred to a results list if the installation state of the respective element is a basic state;
wherein, if the installation state of the respective element is a combination state, a check is performed as to whether the divergence list has at least one element with one of those basic states of which the combination state of the respective element is composed;
wherein the respective element is transferred to the results list if no such element is found in the divergence list;
and wherein, after finding at least one element with one of those basic states of which the combination state of the respective element is composed, the determined parameter value of the respective element is compared in the divergence list with the determined parameter of the at least one element found and the respective element is transferred to the results list if the determined parameter value of the respective element deviates in respect of value or type from the determined parameter value of the at least one element found.

2. Method according to claim 1, **characterised in that** those elements of the results list that have a basic state as an installation state are checked (106) to ascertain whether determined parameter values that match in respect of value and type are listed for these elements.

3. Method according to one of claims 1 to 2, **characterised in that** the results list is forwarded and/or output (107) for further processing, wherein elements of the results list with identical installation states are aggregated.

4. Method according to claims 1 to 3, **characterised in that** at least one voltage at at least one of the at least two output channels (A1 to A8), a current at at least one of the at least two output channels (A1 to A8), a signal at at least one control output (O1 to O4) of the control unit (SE) and/or a signal at at least one input (I1, I2) of the control unit (SE) are predefined (101) as parameters to be determined depending on the respective installation state.

5. Method according to one of the preceding claims, **characterised in that** the predefined installation states are run through in the same sequence (102, 103) when determining the reference values and when determining the current parameter values.

6. Method according to one of the preceding claims, **characterised in that** a plurality of voltage values for the supply voltage are predefined for the predefined installation states (101).

7. Method according to claim 6, **characterised in that** the predefined voltage values are increased in predefined voltage steps from an initial supply voltage up to a nominal voltage or up to an operating limit of the at least one load unit connected to the respective load circuit (102, 103).

8. Method according to one of the preceding claims, **characterised in that**, in the event of a change from one predefined installation state to another predefined installation state, a predefined wait time is observed (102, 103) when determining the reference values and when determining the present parameter values.

9. Method according to one of the preceding claims, **characterised in that** the reference values of the predefined parameters for the predefined installation states are determined by means of a reference system (102).

10. Method according to one of claims 1 to 8, **characterised in that** the reference values of the predefined parameters for the predefined installation states are determined during commissioning of the installation to be checked or during ongoing operation of the system to be checked (102).

## Revendications

1. Procédé mis en œuvre par ordinateur destiné à la vérification de circuits de charge d'un système de commande d'une installation, qui présente au moins une unité de commande (SE), une alimentation électrique (SV) ainsi qu'au moins deux circuits de charge avec respectivement au moins une unité de charge, dans lequel les au moins deux circuits de charge sont alimentés par l'alimentation électrique (SV) par le biais d'au moins deux canaux de sortie (A1 à A8) avec une tension d'alimentation et/ou un courant d'alimentation, qui peuvent varier en intensité de tension et/ou de courant, et dans lequel les au moins deux canaux de sortie (A1 à A8) ainsi que des sorties de commande (O1 à O4) de l'unité de commande (SE) sont commandés par l'unité de commande (SE) et de ce fait des états d'installation sont provoqués, présentant les étapes suivantes :
- prédéfinition d'états d'installation, dans lequel les états d'installation sont répartis au moins en états de base et en états de combinaison, dans lequel des paramètres à déterminer sont associés (101) à chaque état d'installation, dans lequel un état de base est un état d'installation, dans lequel :
i) au moins un canal de sortie (A1 à A8) ou une sortie de commande (O1 à O4) de l'unité de commande est activé ou mis en marche, ou
ii) plusieurs canaux de sortie (A1 à A8) et/ou plusieurs sorties de commande (O1 à O4) sont activés simultanément,
et dans lequel un état de combinaison est une combinaison d'au moins deux états d'installation, qui sont fixés en tant qu'états de base ;
- détermination et enregistrement de valeurs de référence des paramètres pour les états d'installation respectivement définis (102) ;
- détermination et enregistrement de valeurs de paramètres actuelles pour les états d'installation respectivement définis (103) ;
- comparaison des valeurs de paramètres déterminées actuelles avec les valeurs de référence correspondantes (104), dans lequel chaque valeur de paramètre déterminée est enregistrée (105) avec l'état d'installation respectivement associé en tant qu'éléments dans une liste d'écarts, qui s'écartent des valeurs de référence correspondantes ;
- filtrage de la liste d'écarts (106), dans lequel pour chaque élément de la liste d'écarts il est vérifié si l'état d'installation de l'élément respectif est un état de base ou un état de combinaison ;
dans lequel l'élément respectif est transmis dans une liste de résultats lorsque l'état d'installation de l'élément respectif est un état de base ;
dans lequel il est vérifié si la liste d'écarts présente au moins un élément avec un de ces états de base, à partir desquels l'état de combinaison de l'élément respectif est assemblé lorsque l'état d'installation de l'élément respectif est un état de combinaison ;
dans lequel l'élément respectif est transmis dans la liste de résultats lorsque aucun élément de ce type n'est trouvé dans la liste d'écarts ;
et dans lequel après avoir trouvé au moins un élément avec un de ces états de base à partir desquels l'état de combinaison de l'élément respectif est assemblé, dans la liste d'écarts la valeur de paramètre déterminée de l'élément respectif est comparée avec le paramètre déterminé de l'au moins un élément trouvé et l'élément respectif est transmis dans la liste de résultats, lorsque la valeur de paramètre déterminée de l'élément respectif s'écarte en valeur ou en type de la valeur de paramètre déterminée de l'au moins un élément trouvé.

2. Procédé selon la revendication 1, ***caractérisé en ce que*** ces éléments de la liste de résultats, qui présentent un état de base en tant qu'état d'installation, sont vérifiés (106) si des valeurs de paramètres déterminées dans le cas de ces éléments sont indiquées, qui concordent en valeur et en type.

3. Procédé selon l'une quelconque des revendications 1 à 2, ***caractérisé en ce que*** la liste de résultats est transférée et/ou délivrée (107) pour un traitement ultérieur, dans lequel des éléments de la liste de résultats sont assemblés avec des états d'installation identiques.

4. Procédé selon l'une quelconque des revendications 1 à 3, ***caractérisé en ce que*** en tant que paramètres à déterminer en fonction de l'état d'installation respectif au moins une tension est prédéfinie au niveau d'au moins un des au moins deux canaux de sortie (A1 à A8), un courant est prédéfini au niveau d'au moins un des au moins deux canaux de sortie (A1 à A8), un signal est prédéfini au niveau d'au moins une sortie de commande (O1 à O4) de l'unité de commande (SE) et/ou un signal est prédéfini (101) au niveau d'une entrée (I1, I2) de l'unité de commande (SE).

5. Procédé selon l'une quelconque des revendications précédentes, ***caractérisé en ce que*** lors de la détermination des valeurs de référence et lors de la détermination des valeurs de paramètres actuelles les états d'installation prédéfinis sont parcourus (102, 103) dans le même ordre.

6. Procédé selon l'une quelconque des revendications précédentes, ***caractérisé en ce que*** plusieurs valeurs de tension sont prédéfinies (101) pour l'alimentation en tension pour les états d'installation prédéfinis.

7. Procédé selon la revendication 6, ***caractérisé en ce que*** les valeurs de tension prédéfinies sont augmentées (102, 103) lors d'étapes de tension prédéfinies d'une tension d'alimentation de sortie à une tension nominale ou à une limite de fonctionnement de l'au moins une unité de charge raccordée au circuit de charge respectif.

8. Procédé selon l'une quelconque des revendications précédentes, ***caractérisé en ce que*** lors de la détermination des valeurs de référence et lors de la détermination des valeurs de paramètres actuelles lors d'une modification d'un état d'installation prédéfini à un autre état d'installation prédéfini un temps d'attente qui peut être prédéfini est maintenu (102, 103).

9. Procédé selon l'une quelconque des revendications précédentes, ***caractérisé en ce que*** les valeurs de référence des paramètres prédéfinis sont déterminées (102) pour les états d'installation prédéfinis au moyen d'une installation de référence.

10. Procédé selon l'une quelconque des revendications 1 à 8, ***caractérisé en ce que*** les valeurs de référence des paramètres prédéfinis sont déduites (102) pour les états d'installation prédéfinis pendant une mise en service de l'installation à vérifier ou pendant un fonctionnement en cours de l'installation à vérifier.
